# EUROPEAN PATENT APPLICATION

(11) **EP 0 994 506 A1**
(43) Date of publication of application: **19.04.2000**
(21) Application number: 99410131.9
(22) Date of filing: 13.10.1999
(51) Int. Cl.: H01L 21/8242

(54) **Method of making memory cell capacitor**

(30) Priority: 14.10.1998 FR 9813034
(71) Applicant: STMicroelectronics S.A., 94250 Gentilly (FR); FRANCE TELECOM, 75015 Paris (FR)
(72) Inventor: Ciavatti, Jérome, 38400 Saint Martin D'Heres (FR); Mazoyer, Pascale, 38100 Grenoble (FR)
(74) Representative: de Beaumont, Michel

(57) **Abrégé**

L'invention concerne un procédé de fabrication de condensateur de cellule mémoire volatile dans un circuit intégré, et de prise de contact, comprenant les étapes consistant à former une première ouverture (3) dans une première couche isolante (4) pour exposer une première région d'un substrat semiconducteur (1) ; déposer et graver un premier matériau conducteur (5) pour former un plateau horizontal reposant sur un pied vertical formé dans la première ouverture ; déposer de façon conforme un deuxième matériau isolant (6) ; comprenant en outre les étapes consistant à déposer un deuxième matériau conducteur (10) ; former une deuxième ouverture (11) dans la deuxième couche conductrice et la première couche isolante pour exposer une seconde région (2) du substrat ; déposer un troisième matériau conducteur (12) ; et graver avec un même masque les deuxième et troisième matériaux conducteurs.

## Description

La présente invention concerne de façon générale la fabrication de cellules mémoire et, plus particulièrement, un procédé de fabrication de cellules mémoire dynamique à accès aléatoire (DRAM).

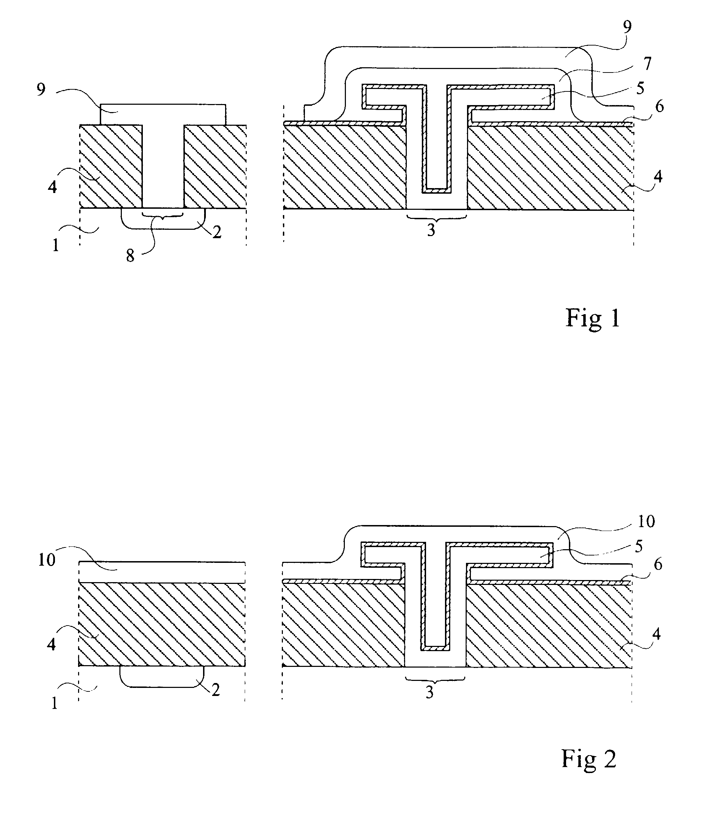

La figure 1 illustre schématiquement, vue en coupe, une partie d'une structure d'une cellule mémoire DRAM formée dans un circuit intégré selon un procédé de fabrication classique. Une telle cellule DRAM comprend un transistor MOS et un condensateur. On suppose ici que le transistor MOS (non représenté) a déjà été formé dans un substrat semiconducteur 1. À ce stade du procédé de fabrication classique, on cherche à former un condensateur et une reprise de contact d'une région semiconductrice 2 formée dans le substrat 1, typiquement en silicium.

Pour ce faire, on forme une première ouverture 3 dans une première couche isolante 4, typiquement en oxyde de silicium, revêtue d'une couche sacrificielle (non représentée), de façon à exposer une première région du substrat 1.

Aux étapes suivantes, on dépose et on grave une première couche conductrice 5, destinée à former une première électrode de condensateur, typiquement en silicium polycristallin. L'épaisseur de la couche 5 peut être choisie en fonction de la largeur de l'ouverture 3 de façon à former un pied évidé comme l'illustre la figure 1. Typiquement, la largeur de l'ouverture 3 est de l'ordre de 0,3 à 0,8 µm, et la couche 5 a une épaisseur de l'ordre de 100 nm.

La couche sacrificielle est ensuite éliminée de sorte que la couche 5 forme un plateau en surélévation. On dépose alors une deuxième couche isolante mince 6, destinée à constituer le diélectrique du condensateur. On dépose et on grave ensuite une deuxième couche conductrice 7, typiquement en silicium polycristallin.

On notera que, pour obtenir un condensateur d'une capacité optimisée, il est souhaitable, comme cela est représenté, que la structure première électrode (couche 5) - diélectrique (couche 6) - deuxième électrode (couche 7) soit également formée dans le pied comme cela est représenté. On doit utiliser un diélectrique très mince, typiquement un multicouche d'oxyde de silicium, de nitrure de silicium et éventuellement une couche supplémentaire d'oxyde de silicium, d'une épaisseur totale inférieure à 6 nm.

Généralement, la première région du substrat 1 avec laquelle le pied de la première électrode 5 est en contact, est la source d'un transistor MOS (non représenté), cette région de source ayant pu être préalablement siliciurée.

Aux étapes suivantes, on forme une deuxième ouverture 8 dans la couche isolante 4, de façon à exposer la région 2.

On dépose ensuite une troisième couche conductrice 9, de préférence métallique, typiquement en tungstène. La couche 9 est gravée selon un contour choisi. On notera en particulier que la partie de la couche 9 située au-dessus de l'ouverture 3 est disjointe de la partie de la couche 9 située au-dessus de l'ouverture 8.

On notera qu'il existe une différence de niveau entre ces parties disjointes. En effet, la portion de la couche métallique 9 située au-dessus et au voisinage de l'ouverture 3 se trouve sensiblement à 500 nm au-dessus de la couche isolante 4, ce qui correspond à la somme de l'épaisseur de l'empilement 6-7-6-5-6-7 constituant la structure de condensateur et de l'épaisseur de la couche 9, les épaisseurs des différentes couches étant sensiblement de respectivement :
couche isolante 6 : 6 nm ;
couche conductrice 5 : 80 nm ;
couche conductrice 7 : 250 nm ; et
couche conductrice 9 : 500 nm.
Le niveau supérieur de la couche métallique 9 au-dessus et au voisinage de l'ouverture 8 se trouve par contre séparé de la couche isolante 4 sensiblement de la seule épaisseur de la couche 9.

On notera également que cette différence de niveau peut en outre être accentuée, au moment de la gravure de la couche conductrice 7 constituant la seconde électrode du condensateur, par une surgravure (non représentée) de la couche isolante 4 dans les régions, notamment environnant la zone où est formée l'ouverture 8, où la couche 7 doit être éliminée.

Aux étapes suivantes (non illustrées), on dépose et on planarise une troisième couche isolante, typiquement en oxyde de silicium. On forme simultanément des troisième et quatrième ouvertures dans la troisième couche isolante. La troisième ouverture est formée de façon à exposer une première région de la couche conductrice 9 au-dessus de la structure de condensateur, par exemple, sensiblement à la verticale de la première ouverture 3. La quatrième ouverture est formée dans la couche isolante de façon à exposer une seconde région de la couche conductrice 9 sensiblement à la verticale de l'ouverture 8. Enfin, on remplit les ouvertures d'une quatrième couche conductrice de préférence métallique, typiquement par dépôts successifs de tungstène et d'aluminium.

Selon une variante (non représentée), la couche isolante 4 n'est pas recouverte initialement d'une couche sacrificielle. Alors, la partie en plateau de la première électrode 5 repose directement sur la couche isolante 4.

Un inconvénient de ce procédé réside dans une diffusion éventuelle des ions métalliques composant la troisième couche conductrice 9 dans la deuxième couche conductrice 7. En effet, le tungstène composant la couche 9 peut réagir avec le silicium polycristallin composant la seconde électrode 7, pénétrer jusqu'à la couche isolante 6 et diffuser dans cette dernière. Alors, ses qualités isolantes sont affectées et la capacité du condensateur diminue.

Pour résoudre ce problème, on doit utiliser une couche 7 de silicium polycristallin particulièrement épaisse, typiquement de 250 nm. Toutefois, cela entraîne des inconvénients supplémentaires : augmentation du coût et encombrement.

Un autre inconvénient d'un tel procédé réside dans le nombre d'étapes de gravure et le nombre de masques de gravure différents, ce qui allonge et augmente le coût du procédé global.

Un autre inconvénient de ce procédé réside dans la photogravure de la seconde électrode 7 du condensateur qui augmente la différence de niveau entre la partie de la couche 9 au-dessus de l'ouverture 3 et la partie de la couche 9 au-dessus de l'ouverture 8, ce qui complique la planarisation de la couche isolante déposée ultérieurement.

Un autre inconvénient réside dans la complexité de réalisation simultanée des troisième et quatrième ouvertures de largeurs sensiblement égales et de profondeurs distinctes.

Pour atteindre ces objets, la présente invention prévoit un procédé de fabrication de condensateur de cellule mémoire volatile dans un circuit intégré, et de prise de contact, comprenant les étapes suivantes :
a) former une première ouverture dans une première couche isolante de façon à exposer une première région d'un substrat semiconducteur ;
b) déposer et graver un premier matériau conducteur pour former un pied vertical dans la première ouverture et un plateau horizontal reposant sur le pied vertical ;
c) déposer de façon conforme un deuxième matériau isolant ;
comprennant en outre les étapes suivantes :
d) déposer un deuxième matériau conducteur ;
e) former une deuxième ouverture dans la deuxième couche conductrice et la première couche isolante de façon à exposer une deuxième région du substrat ;
f) déposer un troisième matériau conducteur ; et
g) graver à l'aide d'un même masque les deuxième et troisième matériaux conducteurs.

Selon un mode de réalisation de l'invention, la couche isolante est initialement revêtue d'une couche sacrificielle et l'étape (c) de dépôt du deuxième matériau isolant est précédée de l'élimination de la couche sacrificielle.

Selon un mode de réalisation de l'invention, la surface supérieure des première et deuxième régions du substrat est siliciurée.

Selon un autre mode de réalisation de l'invention, le siliciure est un siliciure de titane.

Selon un autre mode de réalisation de l'invention, le premier matériau est du silicium polycristallin ou amorphe.

Selon un autre mode de réalisation de l'invention, le deuxième matériau est du nitrure de titane.

Selon un autre mode de réalisation de l'invention, le deuxième matériau est déposé par voie chimique en phase vapeur.

Selon un autre mode de réalisation de l'invention, le deuxième matériau est déposé sur une épaisseur de sensiblement 50 nm.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente partiellement, vue en coupe schématique, la structure d'une cellule mémoire DRAM réalisée selon un procédé de fabrication classique ;
la figure 2 représente partiellement, vue en coupe schématique, la structure d'une cellule mémoire DRAM à une étape intermédiaire de fabrication selon le procédé de la présente invention ;
la figure 3 représente partiellement, vue en coupe schématique, la structure de la cellule mémoire DRAM de la figure 2 à une autre étape de fabrication selon le procédé de l'invention ; et
la figure 4 représente partiellement, vue en coupe schématique, la structure de la cellule mémoire DRAM de la figure 3 à une autre étape de fabrication selon le procédé de l'invention.

Par souci de clarté, les mêmes éléments ont été désignés par les mêmes références aux différentes figures. De plus, comme cela est habituel dans la représentation des circuits intégrés, les différentes vues en coupe ne sont pas à l'échelle.

Le procédé de fabrication selon la présente invention sera exposé ci-après en relation avec les figures 2 à 4.

On veut former une cellule mémoire DRAM dans un circuit intégré. On suppose ici que le transistor MOS (non représenté) a déjà été formé dans un substrat semiconducteur 1. On souhaite former des condensateurs et des reprises de contact sur des régions semiconductrices 2 formées dans un substrat 1, typiquement en silicium. La surface du substrat 1 peut avoir été soumise à un traitement propre à la siliciurer, par exemple en formant un siliciure de titane (TiSi₂).

On commence par les mêmes étapes que celles décrites en relation avec la figure 1 : dépôt d'une première couche isolante 4, dépôt d'une couche sacrificielle (non représentée), formation d'une première ouverture 3, dépôt et gravure d'une première couche conductrice 5, par exemple en silicium polycristallin ou amorphe, élimination de la couche sacrificielle, dépôt d'une deuxième couche isolante 6.

Selon une variante (non représentée), la couche isolante 4 n'est pas recouverte initialement d'une couche sacrificielle. Alors, la partie en plateau de la première électrode 5 repose directement sur la couche isolante 4.

À l'étape suivante, selon l'invention, comme l'illustre la figure 2, on dépose une deuxième couche conductrice 10. Cette couche 10 doit satisfaire aux conditions suivantes : être conforme, ne pas réagir avec la couche 6, isoler la couche 6 des couches supérieures, être facile à graver pour permettre d'y former des ouvertures avec précision, et bien adhérer à la couche 4. La couche 10 est par exemple formée par dépôt chimique en phase vapeur de nitrure de titane (TiN) sur une épaisseur de sensiblement 50 nm.

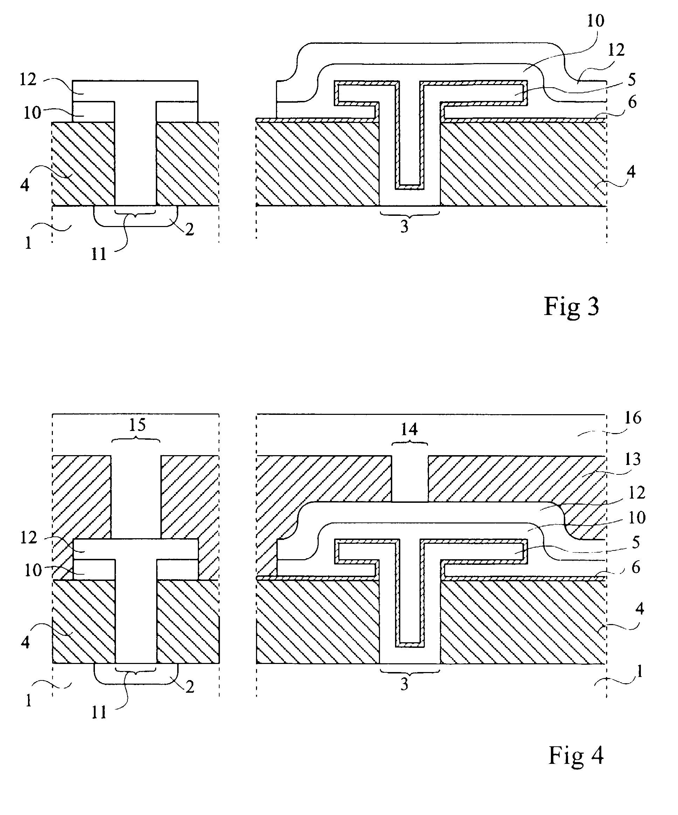

Aux étapes suivantes illustrées en figure 3, on forme dans la couche conductrice 10 et la couche isolante 4 une deuxième ouverture 11 afin d'exposer la région 2.

On notera que la couche 10 n'a pas été gravée à ce stade du procédé de fabrication, ce qui constitue un avantage de la présente invention.

On dépose ensuite une troisième couche conductrice 12, par exemple en tungstène, qui remplit l'ouverture 11 et recouvre l'ensemble de la structure. La couche conductrice 12 et la couche conductrice 10 sont alors gravées selon un contour choisi. On notera en particulier que les parties des couches 12 et 10 situées au-dessus de l'ouverture 3 sont disjointes des parties des couches 10 et 12 situées au-dessus de l'ouverture 11.

Les régions du substrat 1 exposées par les première et deuxième ouvertures 3 et 11, peuvent avoir été précédemment siliciurées. De préférence, la première région est une région de source du transistor MOS de commande du condensateur.

Un avantage de la présente invention est que le nitrure de titane constituant la couche 10 empêche l'interdiffusion des ions métalliques, par exemple tungstène, de la couche 10 dans l'épaisseur de la couche isolante 6. De cette façon, la qualité du diélectrique mince du condensateur n'est pas affectée bien que l'on utilise une seconde électrode d'une épaisseur relativement faible.

Un autre avantage de la présente invention est que les gravures des couches conductrices 10 et 12 peuvent être effectuées à partir d'un même masque.

Un autre avantage de la présente invention réside dans le maintien sous la couche 12 d'une partie de la couche 10 autour de l'ouverture 11. Cet avantage sera exposé ci-après en relation avec la figure 4.

La figure 4 représente l'état de la structure de la figure 3 à un stade ultérieur de sa fabrication.

Après le dépôt de la couche 12 et la gravure des couches 10 et 12, décrits précédemment en relation avec la figure 3, on dépose et on planarise une troisième couche isolante 13, par exemple, en oxyde de silicium.

À l'étape suivante, on forme simultanément des troisième et quatrième ouvertures 14 et 15 dans la couche 13, jusqu'à atteindre le niveau supérieur de la couche 12.

La différence de niveau entre les surfaces supérieures des deux régions ainsi découvertes de la couche conductrice 12 est selon la présente invention indépendante de l'épaisseur de la couche 10. D'une part les épaisseurs des différentes couches déposées sont maintenant, selon l'invention, respectivement :
couche isolante 6 : 6 nm ;
couche conductrice 5 : 80 nm ;
couche conductrice 10 : 80 nm ; et
couche conductrice 12 : 500 nm ;
ce qui conduit à ce que la région de la couche conductrice 12 découverte par l'ouverture 14 se trouve à sensiblement 800 nm (empilement des couches 6, 5, 10 et 12) au-dessus de la couche isolante 4. D'autre part, la région de la couche conductrice 12 découverte par l'ouverture 15 se trouve à sensiblement 600 nm au-dessus de la couche isolante 4 grâce au maintien d'une partie de la couche 10 sous la couche 12 autour de l'ouverture 11, ce qui constitue un avantage de la présente invention.

A l'étape suivante, illustrée également en figure 4, on remplit les ouvertures 14 et 15 d'un quatrième matériau conducteur 16, de préférence métallique, par exemple, en tungstène et aluminium.

Un avantage de la présente invention est que la différence de niveau entre la partie de la couche 12 au-dessus de l'ouverture 3 et la partie de la couche 12 au-dessus de l'ouverture 11 est considérablement réduite, ce qui facilite la planarisation de la couche isolante 13.

Un autre avantage de la présente invention est que la différence de profondeur des ouvertures 14 et 15, par exemple sensiblement de 200 nm, étant plus faible que selon le procédé classique, ces ouvertures, de même largeur, sont plus faciles à réaliser et à remplir.

Bien entendu, la présente invention est susceptible de diverses variantes et modifications qui apparaîtront à l'homme de l'art. En particulier, bien que les matériaux des couches métalliques de remplissage des différentes ouvertures autres que celle liée à la formation de la première électrode du condensateur soient de préférence choisis identiques entre eux et identiques au matériau métallique (tungstène) déposé au-dessus de et latéralement par rapport à ces ouvertures, on peut utiliser des matériaux de remplissage différents pour chacune des différentes ouvertures et/ou différents des matériaux des couches conductrices déposées au-dessus de ces ouvertures. En outre, le dépôt d'une quelconque couche conductrice métallique peut-être précédé du dépôt d'une couche d'adhérence et/ou d'arrêt de gravure.

## Revendications

1. Procédé de fabrication de condensateur de cellule mémoire volatile dans un circuit intégré, et de prise de contact, comprenant les étapes suivantes :
a) former une première ouverture (3) dans une première couche isolante (4) de façon à exposer une première région d'un substrat semiconducteur (1) ;
b) déposer et graver un premier matériau conducteur (5) pour former un pied vertical dans la première ouverture et un plateau horizontal reposant sur le pied vertical ;
c) déposer de façon conforme un deuxième matériau isolant (6) ;
caractérisé en ce qu'il comprend en outre les étapes suivantes :
d) déposer un deuxième matériau conducteur (10) ;
e) former une deuxième ouverture (11) dans la deuxième couche conductrice et la première couche isolante de façon à exposer une deuxième région (2) du substrat ;
f) déposer un troisième matériau conducteur (12) ; et
g) graver à l'aide d'un même masque les deuxième et troisième matériaux conducteurs.

2. Procédé selon la revendication 1, caractérisé en ce que la couche isolante (4) est initialement revêtue d'une couche sacrificielle et en ce que l'étape (c) de dépôt du deuxième matériau isolant (6) est précédée de l'élimination de la couche sacrificielle.

3. Procédé selon la revendication 1, caractérisé en ce que la surface supérieure des première et deuxième régions du substrat (1) est siliciurée.

4. Procédé selon la revendication 3, caractérisé en ce que le siliciure est un siliciure de titane.

5. Procédé selon la revendication 1, caractérisé en ce que le premier matériau (5) est du silicium polycristallin ou amorphe.

6. Procédé selon la revendication 1, caractérisé en ce que le deuxième matériau (10) est du nitrure de titane.

7. Procédé selon la revendication 5, caractérisé en ce que le deuxième matériau (10) est déposé par voie chimique en phase vapeur.

8. Procédé selon la revendication 1, caractérisé en ce que le deuxième matériau (10) est déposé sur une épaisseur de sensiblement 50 nm.
